# EUROPEAN PATENT APPLICATION

(11) **EP 4 793 083 A1**
(43) Date of publication of application: **19.08.2026**
(21) Application number: 25157365.5
(22) Date of filing: 12.02.2025
(51) Int. Cl.: B60L 3/00, B60L 3/04, B60L 58/20, G01R 31/327

(54) **SYSTEMS AND METHOD FOR HANDLING CONTACTORS IN A VEHICLE SYSTEM**

(71) Applicant: Volvo Truck Corporation, 405 08 Göteborg (SE)
(72) Inventor: Gil Rubio, Diego, 414 57 Göteborg (SE); Atefi, Reza, 412 54 Göteborg (SE)
(74) Representative: Valea AB

(57) **Abstract**

The present disclosure relates to a computer system (1000) for handling contactors in a vehicle system (200). The vehicle system (200) comprises a battery (201) electrically connected to a TVS (202) separated by a battery contactor (205a, 205b) and a HV load (203) electrically connected to the TVS (202) separated by a load contactor (208a, 208b). The computer system (1000) comprises processing circuitry (1002) configured to:
- determine that charging has stopped,
- determine to change the battery contactor (205a, 205b) from closed to open state,
- determine that voltage at the TVS (202) is close to or equal to zero,
- determine to change the load contactor (208a, 208b) from open to closed state,
- determine that a result of an insulation monitoring indicates that a risk for insulation error is below a risk threshold,
- determine to change the battery contactor (205a, 205b) from open to closed state.

## Description

### TECHNICAL FIELD

The disclosure relates generally to a computer system, a vehicle system, a vehicle, a computer implemented method, a computer program product and a non-transitory computer-readable storage medium. In particular aspects, the disclosure relates to handling contactors in a vehicle system. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Y-capacitor or Y-capacitance, abbreviated Y-cap, are used for reducing common-mode noise, suppressing electromagnetic interference (EMI) and providing electric insulation between High Voltage (HV) and Low Voltage (LV) systems.

For charging of at least partly electrically driven vehicles, the Y-cap is a parameter that is of interest. In general, it is desired to reduce the Y-cap during charging of an at least partly electrically driven, as it may have benefits such as minimizing leakage current.

It is a strive to further improve handling of Y-cap during charging of an at least partly electrically driven vehicle.

### SUMMARY

According to a first aspect of the disclosure, a computer system for handling contactors in a vehicle system is provided. The vehicle system comprises a battery electrically connected to a Traction Voltage System (TVS) separated by at least one battery contactor. The vehicle system comprises an HV load electrically connected to the TVS separated by at least one load contactor. The computer system comprising processing circuitry configured to:
- determine that charging of the battery has stopped;
- determine to change a state of the pair of battery contactors from a closed state to an open state upon determining that charging of the battery has stopped;
- determine that a voltage at a high voltage measuring point at the TVS is close to or equal to zero;
- determine to change the state of the pair of load contactors from the open state to the closed state when the high voltage at the TVS is detected to be close to or equal to zero;
- determine that a result of an insulation monitoring of at least part of the TVS indicates that a risk for insulation error is below a risk threshold; and
to
- determine to change the state of the pair of battery contactors from the open state to the closed state when the risk for insulation error is below the risk threshold.

The first aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement at the HV load side, pre-charge and voltage measurement circuits, which allows for a compact system design and efficient usage of the limited space in the vehicle.

Optionally in some examples, including in at least one preferred example, the processing circuitry is further configured to:
- determine to perform the insulation monitoring at the TVS; and to
- determine whether or not the result of the insulation monitoring indicates that the risk for insulation error is below the risk threshold.

A technical benefit may include that handling of contactors in the vehicle system is improved. When the risk for insulation error is below the risk threshold, i.e. the risk is low or at an acceptable level, it may be considered safe to close the pair of battery contactors and thereby reconnect the HV load to the battery. The risk for insulation error being below the risk threshold, may be determined by a risk for low insulation in the TVS being low, and hence the risk of electric shock or arching is low.

Optionally in some examples, including in at least one preferred example, the processing circuitry is further configured to:
- determine that there is an indication of a fault in the vehicle system when the risk for insulation error is at or above the risk threshold.

A technical benefit may include that handling of contactors in the vehicle system is improved. When the risk for insulation error is below at or above the risk threshold, i.e. the risk is high and is not at an acceptable level, it may be considered unsafe to close the pair of battery contactors and thereby refrain from reconnecting the HV load to the battery. The risk for insulation error being at or above the risk threshold, may be determined by a risk for low insulation in the TVS being high, and hence the risk of electric shock or arching is high. When there is an indication of a fault, the battery contactor may not change from the open state to the closed state, i.e. the HV load may not be reconnected to the battery. Instead, actions such as fault detection, fault correction, and other precautionary actions to mitigate or remove the indicated fault may be taken. Thus, the risk for the fault causing damage to the vehicle system is reduced or removed.

Optionally in some examples, including in at least one preferred example, the processing circuitry is further configured to:
- determine that the TVS has a safety voltage; and to
- change the state of the pair of battery contactors from the open state to the closed state when the risk for insulation error is below the risk threshold and when the TVS has the safety voltage.

A technical benefit may include that handling of contactors in the vehicle system is improved. A safety voltage may be a voltage being below a voltage threshold, for example below 60 V. When both the condition of the risk for insulation error being below the threshold and the condition of the TVS having the safety voltage needs to be fulfilled in order to change the state of the battery contactor from the open state to the closed state, the safety is increased since the battery contactors enters closed state under specific and controlled conditions. The need for both conditions to be fulfilled also reduces or removes the risk of false triggering of closing the battery contactors. If one of the conditions fails or malfunctions, the other condition may act as a backup condition which still triggers closing of the battery contactors, i.e. reliability of the vehicle system is improved.

Optionally in some examples, including in at least one preferred example, the processing circuitry is further configured to:
- determine that there is an indication of a fault in the vehicle system when the risk for insulation error is at or above the risk threshold and when the TVS has the safety voltage.

A technical benefit may include that handling of contactors in the vehicle system is improved. A safety voltage may be a voltage being below a voltage threshold, for example below 60 V. When both the condition of the risk for low insulation being below the threshold and the condition of the TVS having the safety voltage needs to be fulfilled in order to determine that there is an indication of a fault in the vehicle system, the reliability of the indication is increased. The need for both conditions to be fulfilled also reduces or removes the risk for false fault indication. If one of the conditions fails or malfunctions, the other condition may act as a backup condition which still indicates the fault, i.e. reliability of the vehicle system is improved.

Optionally in some examples, including in at least one preferred example, the processing circuitry is further configured to:
- determine an action to be performed when it has been determined that there is a fault in the vehicle system

A technical benefit may include that handling of contactors in the vehicle system is improved. The action may be for example that a user is informed about the indication of the fault, an alarm may be triggered, troubleshooting may be triggered, the components causing the fault may be located and disconnected etc. This increases safety of the vehicle system. Furthermore, the risk of damage in other parts of the vehicle system is reduced when necessary, actions for the indicated fault are taken.

Optionally in some examples, including in at least one preferred example, the HV load may be a Motor Drive System (MDS) or an HV unit with Y-capacitance above a threshold.

Optionally in some examples, including in at least one preferred example, the insulation monitoring is an Insulation Resistance Monitoring (IRM) or an insulation error monitoring.

According to a second aspect of the disclosure, a vehicle system for handling contactors is provided. The vehicle system comprises:
- a battery electrically connected to a TVS separated by at least one battery contactor; and
- a HV load electrically connected to the TVS separated by at least one load contactor.

The second aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement, pre-charge and voltage measurement circuits, which allows for a compact system design and efficient usage of the limited space in the vehicle.

Technical benefits of the second aspect of the disclosure may correspond to the technical benefits of the first aspect of the disclosure. Further, all examples of the first aspect are applicable to and combinable with all examples of the second aspect, and vice versa.

According to a third aspect of the disclosure, a vehicle is provided. The vehicle comprises the vehicle system of the second aspect and the computer system of the first aspect.

The third aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement, pre-charge and voltage measurement circuits, which allows for a compact system design and efficient usage of the limited space in the vehicle.

Technical benefits of the third aspect of the disclosure may correspond to the technical benefits of the first aspect and the second aspect of the disclosure. Further, all examples of the first aspect and the second aspect are applicable to and combinable with all examples of the third aspect, and vice versa.

According to a fourth aspect of the disclosure, a computer-implemented method for handling contactors in a vehicle system is provided. The vehicle system comprises:
- a battery electrically connected to a TVS separated by at least one battery contactor; and
- a HV load electrically connected to the TVS separated by at least one load contactor.

The method comprises:
- determining, by processing circuitry of a computer system, that charging of the battery has reached stopped;
- determining, by processing circuitry of a computer system, to change a state of the pair of battery contactors from a closed state to an open state upon determining that charging of the battery has reached the threshold;
- determining, by the processing circuitry, that a voltage at a high voltage measuring point at the TVS is close to or equal to zero;
- determining, by the processing circuitry, to change the state of the pair of load contactors from the open state to the closed state when the voltage is detected to be close to or equal to zero;
- determining, by the processing circuitry, that a result of an
- insulation monitoring of at least part of the TVS indicates that a risk for insulation error is below a risk threshold; and
- determining, by the processing circuitry to change the state of the pair of battery contactors from the open state to the closed state when the risk for insulation error is below the risk threshold.

The fourth aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement, pre-charge and voltage measurement circuits, which allows for a compact system design and efficient usage of the limited space in the vehicle.

Technical benefits of the fourth aspect of the disclosure may correspond to the technical benefits of the first aspect, the second aspect and the third aspect of the disclosure. Further, all examples of the first aspect, the second aspect and the third aspect are applicable to and combinable with all examples of the fourth aspect, and vice versa.

Optionally in some examples, including in at least one preferred example, the method may further comprise:
- determining, by the processing circuitry, to perform the insulation monitoring at the TVS; and
- determining, by the processing circuitry, whether or not the result of the insulation monitoring indicates that the risk for insulation error is below the risk threshold.

A technical benefit may include that handling of contactors in the vehicle system is improved. When the risk for insulation error is below the risk threshold, i.e. the risk is low or at an acceptable level, it may be considered safe to close the pair of battery contactors and thereby reconnect the HV load to the battery. The risk for insulation error being below the risk threshold, may be determined by a risk for low insulation in the TVS being low, and hence the risk of electric shock or arching is low.

Optionally in some examples, including in at least one preferred example, the method may further comprise:
- determining, by the processing circuitry, that there is an indication of a fault in the vehicle system when the risk for insulation error is at or above the risk threshold.

A technical benefit may include that handling of contactors in the vehicle system is improved. When there is an indication of a fault, the battery contactor may not change from the open state to the closed state, i.e. the HV load may not be reconnected to the HV load. Instead, actions such as fault detection, fault correction, and other precautionary actions to mitigate or remove the indicated fault may be taken. Thus, the risk for the fault causing damage to the vehicle system is reduced or removed. When the risk for insulation error is below at or above the risk threshold, i.e. the risk is high and is not at an acceptable level, it may be considered unsafe to close the pair of battery contactors and thereby refrain from reconnecting the HV load to the battery. The risk for insulation error being at or above the risk threshold, may be determined by a risk for low insulation in the TVS being high, and hence the risk of electric shock or arching is high.

According to a fifth aspect of the disclosure, a computer program product is provided. The computer program product comprises program code for performing, when executed by a processing circuitry, the method of the first aspect.

The fifth aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement, pre-charge and voltage measurement circuits, which allows for a compact system design and efficient usage of the limited space in the vehicle.

Technical benefits of the fifth aspect of the disclosure may correspond to the technical benefits of the first aspect, the second aspect, the third aspect and the fourth aspect of the disclosure. Further, all examples of the first aspect, the second aspect, the third aspect and the fourth aspect are applicable to and combinable with all examples of the fifth aspect, and vice versa.

According to a sixth aspect of the disclosure, a non-transitory computer-readable storage medium is provided. The non-transitory computer-readable storage medium comprising instructions, which when executed by a processing circuitry, cause the processing circuitry to perform the method of the first aspect.

The sixth aspect of the disclosure may seek to improve handling of contactors in the vehicle system. A technical benefit may include that handling of contactors in the vehicle system is improved. The battery is disconnected before reconnecting the HV load. Furthermore, there is a reduced need for Isolation Resistance Measurement, pre-charge and voltage measurement circuits, which allows for a compact system design and efficient usage of the limited space in the vehicle.

Technical benefits of the sixth aspect of the disclosure may correspond to the technical benefits of the first aspect, the second aspect, the third aspect, the fourth aspect and the fifth aspect of the disclosure. Further, all examples of the first aspect, the second aspect, the third aspect, the fourth aspect and the fifth aspect are applicable to and combinable with all examples of the sixth aspect, and vice versa.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary schematic drawing illustrating a vehicle, according to an example.
**FIG. 2** is an exemplary schematic drawing illustrating a vehicle system, according to an example.
**FIG. 3** is an exemplary schematic drawing illustrating a vehicle system, according to an example.
**FIG. 4** is an exemplary schematic drawing illustrating a vehicle system, according to an example.
**FIG. 5** is an exemplary schematic drawing illustrating a vehicle system, according to an example.
**FIG. 6** is an exemplary schematic drawing illustrating a vehicle system, according to an example.
**FIG. 7** is a flow chart of an exemplary method, according to an example.
**FIG. 8** is a flow chart of an exemplary method, according to an example.
**FIG. 9** is another view of **FIG. 1**, according to an example.
**FIG. 10** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Y-capacitor or Y-capacitance, abbreviated Y-cap, are used for reducing common-mode noise, suppressing electromagnetic interference (EMI) and providing electric insulation between High Voltage (HV) and Low Voltage (LV) systems.

For charging of at least partly electrically driven vehicles, the Y-cap is a parameter that is of interest. In general, it is desired to reduce the Y-cap during charging of an at least partly electrically driven, as it may have benefits such as minimizing leakage current.

It is a strive to further improve handling of Y-cap during charging of an at least partly electrically driven vehicle, i.e. the Y-cap between the DC lines and the chassis ground of the vehicle.

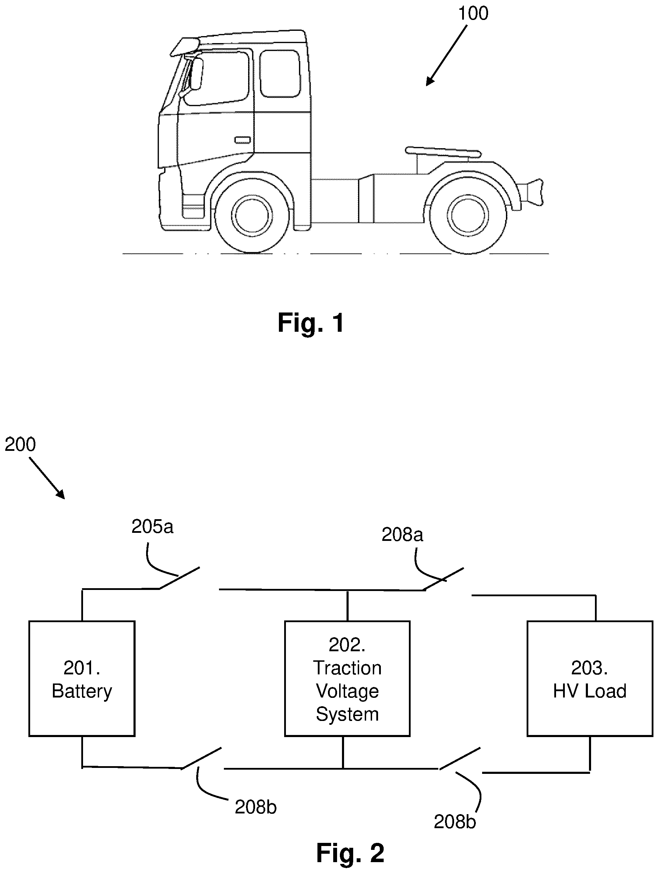

**FIG. 1** is an exemplary schematic drawing illustrating a vehicle **100**, according to an example. The vehicle **100** is a heavy-duty vehicle, such as truck, bus, and construction equipment, among other vehicle types. Although the disclosure may be described with respect to a particular vehicle, the disclosure is not restricted to any particular vehicle, but may be also used in other vehicles such as trailers, wheel loaders, articulated haulers, excavators, backhoe loaders, passenger cars, marine vessels etc. It may also be applied in various industrial construction machines or working machines.

The vehicle **100** may be a truck for towing one or more trailers (not shown). It shall however be understood that the vehicle may be any other type of vehicle, such as another type of truck, a bus, a passenger car, and construction equipment, such as an excavator, a wheel loader, etc. The vehicle **100** may be operated by a user (not shown) and/or be at least partly automatically driven, i.e., it may be a vehicle comprising autonomous driving capabilities. The vehicle **100** may be a fully electric vehicle or a hybrid vehicle. Using other words, the vehicle **100** may be an at least partly electrically driven vehicle. The vehicle **100** may comprise one or more electric motors/generators and/or an internal combustion engine (not shown) for driving the vehicle **100.**

The term vehicle will be used herein when referring to any of the above types of vehicles.

Since the vehicle **100** is an at least partly electrically driven vehicle, it is arranged to be charged with electric power. The charging may be done at a charging station. The charging may be done via a charging connection between the vehicle **100** and the charging station. The charging connection may be a wired charging cable or a wireless charging link. Directions used herein, e.g. horizontal, vertical, lateral, relate to when the vehicle **100** stands on flat ground.

**FIG. 2** is an exemplary schematic drawing illustrating a vehicle system **200**, according to an example. At least part of the vehicle system **200** may be arranged to be comprised in the vehicle **100.**

The vehicle system **200** comprises a battery **201**, a TVS **202** and an HV load **203.**

The battery **201** may be a traction battery arranged to store electric energy used to power to the vehicle **100,** the vehicle's drivetrain, the TVS **202** and the HV load **203.**

The TVS **202** may be a high-voltage electric system arranged to power the HV load **203** using power from the battery **201.** The TVS **202** may comprise, for example electric motors, power electronics such as inverter, converter, etc. The battery **201** is not comprised in the TVS **202.**

The HV load **203** may be a Motor Drive System (MDS) or a HV unit with Y-capacitance above a threshold. The threshold may be a capacitance threshold. The MDS comprises for example an electric motor arranged to convert electric energy from the battery **201** into motion energy to drive the vehicle **100.** The MDS may be referred to as an electric MDS, an electric machine drive system or an electric motor drive system. The HV unit with Y-capacitance above the threshold may be for example HV fan, HV Pump, etc. The HV load **203** may not be necessary for charging the vehicle **100.** There may *n* HV loads **203,** where *n* is a positive integer.

The battery **201** is electrically connected to the TVS **202** separated by at least one battery contactor **205a, 205b.** In other words, there may be a pair of battery contactors **205a, 205b** connected between the battery **201** and the TVS **202** that may be arranged to allow or interrupt the electric connection between them. The battery **201** may be electrically connected in parallel to the TVS **202.** When the battery **201** is electrically connected in parallel to the TVS **202,** the voltage across the battery **201** is the same as the voltage over the TVS **202** is the same, and they may or may not have the same current flow.

The HV load **203** is electrically connected to the TVS **202** separated by at least one load contactor **208a, 208b.** In other words, there may be a pair of load contactors **208a, 208b** connected between the TVS **202** and the HV load **203** that may be arranged to allow and interrupt the electric connection between them. The HV load **203** may be electrically connected in parallel to the TVS **202.** When the battery **201** is electrically connected in parallel to the TVS **202,** the voltage across the battery **201** is the same as the voltage over the TVS **202** is the same, and they may or may not have the same current flow.

The term electrically connected may refer to that there is an electric connection, e.g. a conductive path between two units allowing electric current to flow between them. Electrically connected may be referred to as wired to, linked via an electric connection, electrically interfaced, etc.

The term contactor used herein refers to a high power electric switch arranged to connect and disconnect the battery **201** from the TVS **202,** and the HV load **203** from the TVS **202.** The contactor may be in an open or closed state. When it is in a closed state, electric connection is allowed. When it is in an open state, the electric connection is interrupted. When a contactor is in open state, it may be disengaged, turned off, disabled, deactivated, disconnected, off, idle, released, first state, etc. When a contactor is in closed state, it may be engaged, turned on, enabled, activated, connected, on, conducting, second state etc.

The top and bottom horizontal lines, separated by the at least one battery connector **205a, 205b** and the at least one load connector **208a, 208b** represent the main HV DC bus of the vehicle system **200.**

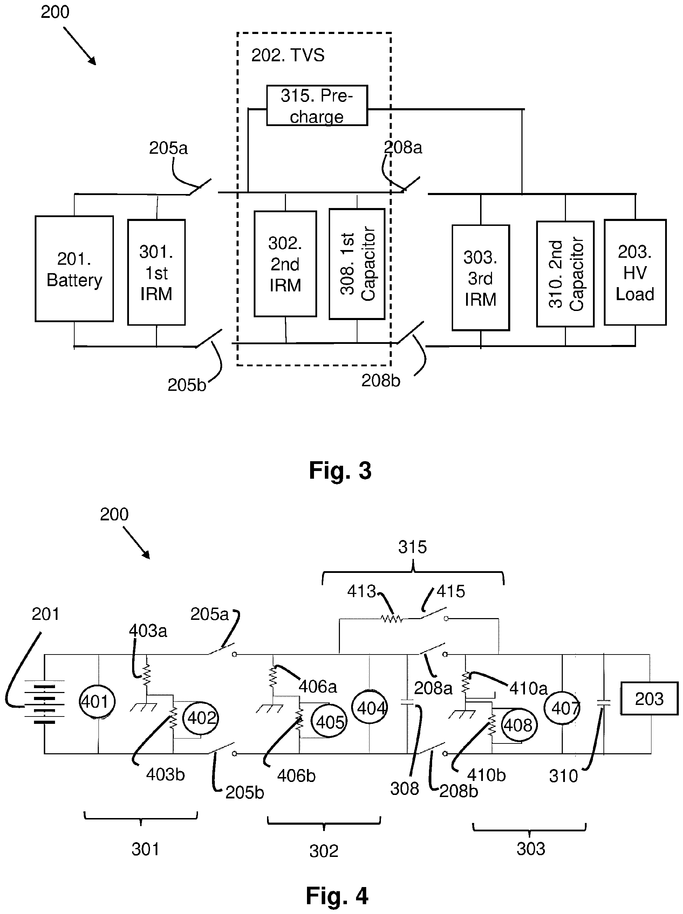

**FIG. 3** is an exemplary schematic drawing illustrating a vehicle system **200,** according to an example. The vehicle system 200 comprises a battery **201**, a TVS **202** and an HV load **203.**

The battery **201** is electrically connected to the TVS **202** separated by at least one battery contactor **205a, 205b.** The HV load **203** is electrically connected to the TVS **202** separated by at least one load contactor **208a, 208b.**

The vehicle system **200** comprise a first IRM **301,** a second IRM **302** and a third IRM **302** located between the battery **201** and the HV load **203.** IRM, short for Insulation Resistance Monitoring, is a unit, system or circuit arranged to monitor insulation resistance. When the monitored insulation resistance is below a resistance threshold, then this may be an indication of a potential insulation failure in the vehicle system **200.**

The vehicle system **200** comprises a first capacitor **308** and a second capacitor **310.** The first and second capacitors **308, 310** may each be X-capacitors. A X-capacitor is arranged to filter out and suppress differential mode noise. The X-capacitor may be connected between pole to pole. The X-capacitor is arranged to consume energy before the charging of the battery **201** starts. If the amount of energy stored in the X-capacitor has exceeded a limit, then there may be an indication of a malfunction during the pre-charge.

The IRM measures and monitors insulation resistance by introducing a test voltage and detecting leakage currents. The first and second capacitors **308, 310** provides an additional path for the leakage current, which affects the measurements performed by the IRM.

Seen from the left in **FIG. 3****,** the battery **201** is connected to the first IRM **301,** the first IRM **301** is connected to the second IRM **302.** The at least one battery contactor **205a, 205b** is located between the first and second IRM **301, 302.** The second IRM **302** is connected to the first capacitor **308.** The first capacitor **308** is connected to the third IRM **303.** The at least one load contactor **208a, 208b** is located between the first capacitor **308** and the third IRM **303.** The third IRM **303** is connected to the second capacitor **310.** The second capacitor **310** is connected to the HV load **203.**

The battery **201,** the first, second and third IRM **301, 302, 303,** the first and second capacitors **308, 310** and the HV load **203** are electrically connected in parallel to each other. When they are electrically connected in parallel, the voltage across each of the entities are the same, but the current flow through each entity may or may not be the same.

A pre-charge circuit **315** is connected over the second IRM **302,** the first capacitor **208,** the at least one load contactor **308a, 308b** and the third IRM **303.**

The TVS **202** comprises the second IRM **302,** the first capacitor **308,** the at least one load contactor **208a, 208b** and the pre-charge circuit **305,** as indicated with the dashed box in **FIG. 3****.** TVS **202** may be any component that is not galvanically isolated from the common HV bus.

**FIG. 4** is an exemplary schematic drawing illustrating a vehicle system **200,** according to an example. The vehicle system **200** illustrated in **FIG. 4** is a more detailed example of the vehicle system **200** illustrated in **FIG. 3****.** Compared to **FIG. 3, FIG. 4** shows for examples details of the three IRMs **301, 302, 303.**

Similar to the vehicle system **200** in **FIG. 3****,** the vehicle system **200** exemplified in **FIG. 4** comprises a battery **201** and a HV load **203.** The TVS **202** is located between the battery **201** and the HV load **203.** The battery **201** is electrically connected to the TVS **202** separated by the pair of battery contactors **205a, 205b**. The HV load **203** is electrically connected to the TVS **202** separated by the pair of load contactors **208a, 208**b.

**FIG. 4** illustrates that the vehicle system **200** comprises the first, second and third IRM **301, 302, 303** and the first and second capacitors **308, 310.**

The first IRM **301** is exemplified in **FIG. 4** to comprise comprises a first voltage measurement point **401,** a second voltage measurement point **402** and two serially connected resistors **401a, 401b.** The first voltage measurement point **401** may be referred to as V_pos_neg _BC, where V refers to voltage, pos refers to positive, neg refers to negative and BC refers to battery circuit. At the first voltage measurement point **401,** the voltage between the positive and negative poles of the battery **201** is measured.

At the second voltage measurement point **402,** the voltage between the chassis and the negative pole of the battery **201** is measured. This voltage measurement point may be referred to as V_chassis_neg_BC.

The second IRM **302** is exemplified in **FIG. 4** to comprise comprises a third voltage measurement point **404,** a fourth voltage measurement point **405** and two serially connected resistors **406a, 406b.** The third voltage measurement point **404** may be referred to as V_pos_neg_AC, where V refers to voltage, pos refers to positive, neg refers to negative and AC refers to Alternating Current. At the third voltage measurement point **404,** the voltage between the positive and negative poles of the battery **201** is measured.

At the fourth voltage measurement point **405,** the voltage between the chassis and the negative pole of the battery **201** is measured. This voltage measurement point may be referred to as V_chassis_neg_AC.

The third IRM **303** is exemplified in **FIG. 4** to comprise comprises a fifth voltage measurement point **407,** a sixth voltage measurement point **408** and two serially connected resistors **410a, 410b.** The fifth voltage measurement point **407** may be referred to as V_pos_neg_MDS, where V refers to voltage, pos refers to positive, neg refers to negative and MDS refers to the HV load **203.** At the fifth voltage measurement point **407,** the voltage between the positive and negative poles of the battery **201** is measured.

At the sixth voltage measurement point **408,** the voltage between the chassis and the negative pole of the battery **201** is measured. This voltage measurement point may be referred to as V_chassis_neg_MDS.

The pre-charge circuit **315** is exemplified in **FIG. 4** to comprise a resistor **413** serially connected to a pre-charge contactor **415.**

As mentioned above, it is a strive to further improve handling of Y-cap during charging, i.e. the Y-cap between the DC lines and the chassis ground of the vehicle **100.** One way of improving handling of the Y-cap may be to reduce the Y-cap when DC charging the vehicle **100** and this may be done by isolating HV load **203** such as the Electric Machine Drive from the main HV DC bus by means of contactors.

By doing that, there are numerous LV and HV logic functionalities associated with Isolation Resistance and Voltage Measurements of the new bus as well as pre-charge the X cap in the Electric Machine Drive. By running the method which will now be described, the extra LV and HV circuitries illustrated in **FIG. 3** and **FIG. 4** may be avoided, reducing complexity, component count and having both cost and space-related benefits. The circuits that may be avoided is the pre-charge circuit **315** and the third IRM **303.**

The present disclosure handles Y-cap by disconnection of the HV load **203,** e.g. the EMD, and removing certain components, i.e. the third IRM **303,** pre-charge circuit **315** and voltage measurement circuit **407,** that previously have been required for a safe reconnection of the HV load **203.** This will allow for a more compact switch design and a more efficient usage of the limited space in the vehicle **100.** In the present disclosure, the battery **203** is disconnected before reconnecting the HV load **203** at the end of charging session.

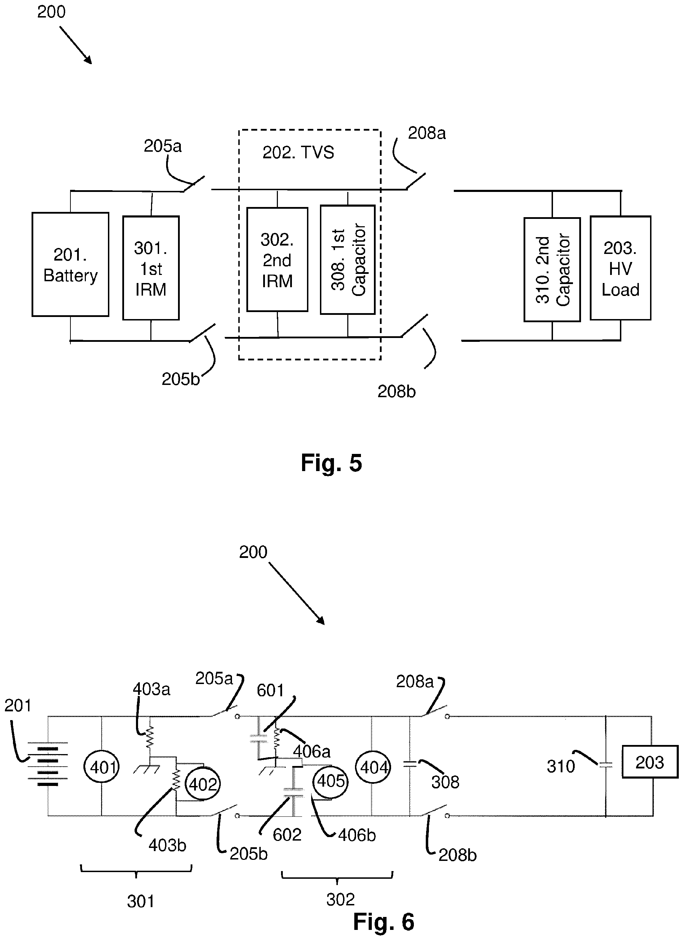

**FIG. 5** is an exemplary schematic drawing illustrating a vehicle system **200,** according to an example. The vehicle system **200** comprises a battery **201,** a TVS **202** and an HV load **203.**

The battery **201** is electrically connected to the TVS **202** separated by at least one battery contactor **205a, 205b.** The HV load **203** is electrically connected to the TVS **202** separated by at least one load contactor **208a, 208b.**

The vehicle system **200** may comprise a first IRM **301** and a second IRM **302** located between the battery **201** and the HV load **203.**

The vehicle system **200** may comprise a first capacitor **308** and a second capacitor **310.** The first and second capacitors **308, 310** may each be X-capacitors. An X-capacitor is arranged to filter out and suppress common mode noise. The Y-capacitor may be connected between pole to pole. The X-capacitor is arranged to consume energy before the charging of the battery **201** starts. If the amount of energy stored in the X-capacitor has exceeded a limit, then there may be an indication of a malfunction. Thus, the X-capacitor may be referred to as a safety capacitor.

The IRM measures and monitors insulation resistance by introducing a test voltage and detecting leakage currents. The first and second capacitors **308, 310** provides an additional path for the leakage current, which affects the measurements performed by the IRM.

Seen from the left in **FIG. 5****,** the battery **201** is connected to the first IRM **301,** the first IRM **301** is connected to the second IRM **302.** The at least one battery contactor **205a, 205b** is located between the first and second IRM **301, 302.** The second IRM **302** is connected to the first capacitor **308.** The first capacitor **308** is connected to the second capacitor **310.** The at least one load contactor **208a, 208b** is located between the first capacitor **308** and the second capacitor **310.** The second capacitor **310** is connected to the HV load **203.**

The battery **201,** the first and second IRM **301, 302,** the first and second capacitors **308, 310** and the HV load **203** are electrically connected in parallel to each other. When they are electrically connected in parallel, the voltage across each of the entities are the same, but the current flow through each entity may or may not be the same.

When comparing **FIG. 5** with **FIG. 3****,** it is clearly seen that **FIG. 5** shows less components than **FIG. 3****,** i.e. the vehicle system **200** of **FIG. 5** is a compact switch design, a low weight system and a more efficient usage of the limited space in the vehicle **100.** With fewer components, the risk for malfunction, wear and tear is reduced. Furthermore, it is easier to perform troubleshooting since fewer components needs to be checked. A component may generate heat, so fewer components may reduce power dissipation and improves thermal performance of the vehicle system **200.**

**FIG. 6** is an exemplary schematic drawing illustrating a vehicle system **200,** according to an example. The vehicle system **200** illustrated in **FIG. 6** is a more detailed example of the vehicle system **200** illustrated in **FIG. 6****.** Compared to **FIG. 5, FIG. 6** shows for examples details of the two IRMs **301, 302.**

Similar to the vehicle system **200** in **FIG. 5****,** the vehicle system **200** exemplified in **FIG. 6** comprises a battery **201** and an HV load **203.** The TVS **202** is located between the battery **201** and the HV load **203.** The battery **201** is electrically connected to the TVS **202** separated by the pair of battery contactors **205a, 205b.** The HV load **203** is electrically connected to the TVS **202** separated by the pair of load contactors **208a, 208b.**

**FIG. 6** illustrates that the vehicle system **200** comprises the first and second IRM **301, 302** and the first and second capacitors **308, 310.** The first and second capacitors **308, 310** may be X-capacitors. The vehicle system **200** may comprise at least one Y-capacitor, in addition to the X-capacitors. Some example locations of the Y-capacitors are seen in fig. 6 with the first Y-capacitor **601** and a second Y-capacitor **602.** These Y-capacitors **601, 602** are capacitances between pole to chassis.

The first IRM **301** is exemplified in **FIG. 6** to comprise comprises a first voltage measurement point **401,** a second voltage measurement point **402** and two serially connected resistors **401a, 401b.** The first voltage measurement point **401** may be referred to as V_pos_neg_BC, where V refers to voltage, pos refers to positive, neg refers to negative and BC refers to battery circuit. At the first voltage measurement point **401,** the voltage between the positive and negative poles of the battery **201** is measured.

At the second voltage measurement point **402,** the voltage between the chassis and the negative pole of the battery **201** is measured. This voltage measurement point may be referred to as V_chassis_neg_BC.

The second IRM **302** is exemplified in **FIG. 6** to comprise comprises a third voltage measurement point **404,** a fourth voltage measurement point **405** and two serially connected resistors **406a, 406b.** The third voltage measurement point **404** may be referred to as V_pos_neg_AC, where V refers to voltage, pos refers to positive, neg refers to negative and AC refers to Alternating Current. At the third voltage measurement point **404,** the voltage between the positive and negative poles of the battery **201** is measured.

At the fourth voltage measurement point **405,** the voltage between the chassis and the negative pole of the battery **201** is measured. This voltage measurement point may be referred to as V_chassis_neg_AC.

The at least one battery contactor **205a, 205b** may be in a closed state or open state. When at least one battery contactor **205a, 205b** is in open state, it may be disengaged, turned off, disabled, deactivated, disconnected, off, idle, released, first state, etc. When at least one battery contactor **205a, 205b** is in closed state, it may be engaged, turned on, enabled, activated, connected, on, conducting, second state etc. When the vehicle system **200** comprises two, three or more battery contactors **205a, 205b,** then all of them are in the same state. When the battery contactors **205a, 205b** changes state, all battery contactors **205a, 205b** may change state substantially at the same time, possibly some time delay tolerance.

The at least one load contactors **208a, 208b** may be in a closed state or open state. The at least one load contactors **208a, 208b** may be in a closed state or open state. When at least one battery load contactors **208a, 208b** is in open state, it may be disengaged, turned off, disabled, deactivated, disconnected, off, idle, released, first state, etc. When at least one load contactors **208a, 208b** is in closed state, it may be engaged, turned on, enabled, activated, connected, on, conducting, second state etc. When the vehicle system **200** comprises two, three or more load contactors 208a, 208b, then all of them are in the same state. When the load contactors **208a, 208b** changes state, all load contactors **208a, 208b** may change state substantially at the same time, possibly some time delay tolerance.

The at least one battery contactor **205a, 205b** may be in the same state as the at least one load contactor **208a, 208b,** or the at least one battery contactor **205a, 205b** may be in a different state than the at least one load contactor **208a, 208b.**

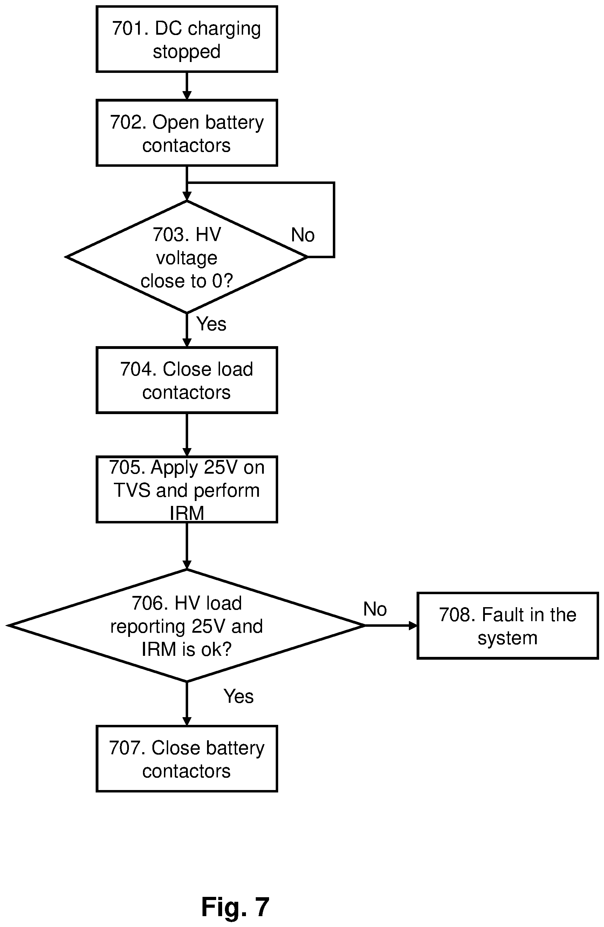

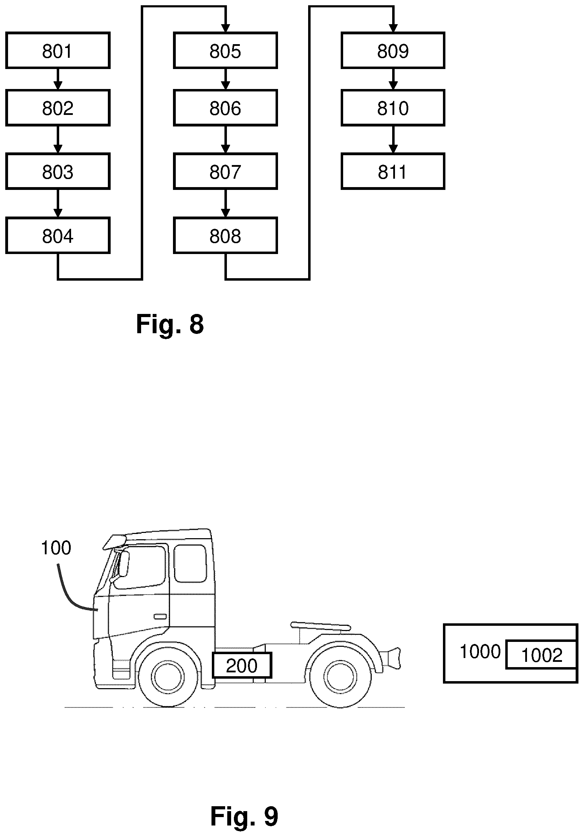

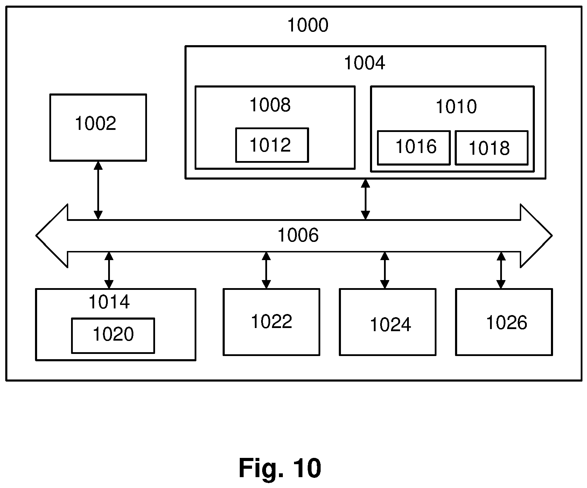

**FIG. 7** is a flow chart of an exemplary method, according to an example. The method may be performed by a computer system **1000** or a processing circuitry **1002** comprised in the computer system **1000.** The computer system **1000** may be located onboard the vehicle **100** or offboard the vehicle **100.** The reference numbers **1000** and **1002** are illustrated in **FIG. 9** and **FIG. 10** which will be described in detail later. Before step **701** is performed, the at least one battery contactors **205a, 205b** are closed and the at least one load contactors **208a, 208b** are open. The method in **FIG. 7** comprises at least one of the following steps, which steps may be performed in any suitable order than described below:
Step **701:** DC charging of the vehicle **100** is stopped. The DC charging may be stopped when the charging session is finished, when the vehicle **100** has been charged with a certain amount of charge, when a charging threshold has been reached, when a certain time from charging start has lapsed, when a charging stop has been triggered by a user, by the computer system **100** or by some other onboard or offboard system, that a charging cable has been removed from the charging inlet of the vehicle **100** etc. It is necessary for the DC charging of the vehicle **100** to stop before proceeding to step **702** because otherwise there would be current flowing through the contactors when they are being opened, which means that they would weld and cause severe consequences.
Step **702:** The at least one battery contactor **205a, 205b** is opened, i.e. its state is changed from closed state to open state.
Step **703:** The voltage at a voltage measuring point at the TVS **202** is measured and it is checked if this measured voltage is zero or close to zero. Close to zero may be that the voltage does not differ more than a predetermined amount from zero. It is the value of the voltage that should be high that is very low or close to zero. The measured voltage may be a high voltage. If the voltage is zero or close to zero, as indicated with yes in **FIG. 7****,** the method proceeds to step **704.** If the voltage is not zero or close to zero, as indicated with no in **FIG. 7****,** step **703** is repeated.
Step **704:** This step is performed if the voltage measured in step **703** is zero or close to zero. The at least one load contactor **208a, 208b** is closed.
Step **705:** Insulation monitoring is performed. The purpose of the insulation monitoring may be described as monitoring whether or not the risk of low insulation in the TVS **202** is low hence there is low risks of electric shock or arching. A safety voltage may be applied to the TVS **202.** The safety voltage may be for example below 60 V.
Step **706:** It is checked if the result of the insulation monitoring is ok. The result of the insulation monitoring may be ok when the result indicates that a risk for insulation error is below a risk threshold. Insulation error may be an error in the monitored insulation resistance in the TVS **202.** The risk for insulation error being below the risk threshold may be determined by a risk for low insulation being below another risk threshold, e.g. that the risk for low insulation is low. The Y-cap may be below a capacitance threshold when the risk for insulation error is below the risk threshold. The insulation may be low when it is below an insulation threshold. It may be checked if the HV load **203** has the safety voltage. When the result of the insulation monitoring is not ok, the method proceeds to step **708.** When the result of the insulation monitoring is ok, then the method proceeds to step **707.**
Step **707:** The at least one battery contactors **205a, 205b** are closed when the result of the insulation monitoring is ok. When the insulation monitoring is ok, the risk for insulation error is below the risk threshold, i.e. the Y-cap is below the capacitance threshold, it may be determined that there are no indications of faults in the vehicle system **200** and it is safe to connect the battery **201** and the HV load **203.** In step **707,** the at least one battery contactor **205a, 205b** changes from open state to closed state. A second condition for closing the at least on battery contactors **205a, 205b** may be that the HV load **203** has the safety voltage. After step **707** has been performed, the at least one battery contactors **205a, 205b** and the at least one load contactors **208a, 208b** are both closed such that the battery **201** and the HV load **203** are connected and the HV load **203** may be powered with electric power from the battery **201.**
Step **708:** When the insulation monitoring is not ok, then it may be an indication of a fault in the vehicle system **200.** A second condition for determining that there is an indication of a system fault may be that the HV load **203** does not have the safety voltage. When there is an indication of a fault in the vehicle system **200,** it may not be safe to connect the battery **201** and the HV load **203.**

**FIG. 8** is a flow chart of an exemplary method, according to an example. The method is a computer-implemented method for handling contactors in a vehicle system **200.** The vehicle system **200** comprises a battery **201** electrically connected to a TVS **202** separated by at least one battery contactor **205a, 205b.** The vehicle system **200** comprises a HV load **203** electrically connected in parallel to the TVS **202** separated by at least one load contactor **208a, 208b.** When they are electrically connected in parallel, the voltage across each of the HV load **203** and the TVS **202** are the same, but the current flow through each of them may or may not be the same. The HV load **203** may be a MDS or an HV unit with Y-capacitance above a threshold.

The method may be performed by a computer system **1000** or a processing circuitry **1002** comprised in the computer system **1000.** The computer system **1000** may be located onboard the vehicle **100,** offboard the vehicle **100,** or partly onboard or offboard the vehicle **100.** The reference numbers **1000** and **1002** are illustrated in **FIG. 9** and **FIG. 10** which will be described in detail later. Before step **801** is performed, the at least one battery contactors **205a, 205b** are closed and the at least one load contactors **208a, 208b** are open.

The method in **FIG. 8** comprises at least one of the following steps, which steps may be performed in any suitable order than described below:
Step **801:** This step corresponds to step **701** in **FIG. 7****.** The processing circuitry **1002** of a computer system **1000** determines that charging of the battery **201** has stopped.

The charging may be stopped when the charging session is finished, when the vehicle **100** has been charged with a certain amount of charge, when a charging threshold has been reached, when a certain time from charging start has lapsed, when a charging stop has been triggered by a user, by the computer system **100** or by some other onboard or offboard system, that a charging cable has been removed from the charging inlet of the vehicle **100** etc.

The processing circuitry **1002** may determine that the charging has stopped by obtaining information about the stopped charging. There may be a sensor, monitoring unit or any other suitable unit arranged to determine that the charging of the battery **201** has stopped and to provide information about the stopped charging to the processing circuitry **1002.** It is necessary for the DC charging of the vehicle **100** to stop before proceeding to step **702** because otherwise there would be current flowing through the contactors when they are being opened, which means that they would weld and cause severe consequences.

Step **802:** This step corresponds to step **702** in **FIG. 7****.** The processing circuitry **1002** determines to change a state of the at least one battery contactors **205a, 205b** from a closed state to an open state upon determining that charging of the battery 201 has reached the threshold. The processing circuitry **1002** may send instructions to the at least one battery contactor **205a, 205b** to enter an open state. The processing circuitry **1002** controls the change from closed state to open state. Controlling the change from closed state to open state may comprise triggering the change of the state, activating the change of the state, initiating the change of the state etc. As a consequence of step 802 may be that the at least one battery contactor **205a, 206b** changes from closed state to open state.

Step **803:** This step corresponds to step **703** in **FIG. 7****.** The processing circuitry **1002** determines that a voltage at a high voltage measuring point at the TVS 202 is close to or equal to zero. It is the value of the voltage that should be high that is very low or close to zero. The processing circuitry **1002** may determine this by obtaining information from a voltage sensor, voltage monitoring unit or any other suitable unit for monitoring voltage. When the voltage is close to zero, the voltage does not differ more than a predetermined amount of voltage from zero.

Step **804:** This step corresponds to step **703** in **FIG. 7****.** The processing circuitry **1002** may determine that the TVS 202 has a safety voltage. In other words, the processing circuitry **1002** may determine that the TVS **202** reaches a safe voltage level, e.g. below 60V.

A safety voltage may be a voltage being below a voltage threshold, for example below 60 V.

Step **805:** This step corresponds to step **704** in **FIG. 7****.** The processing circuitry **1002** determines to change the state of the at least one load contactors **208a, 208b** from the open state to the closed state when the voltage is detected to be close to or equal to zero. The processing circuitry **1002** may determine to change the state of the at least one battery contactor **205a, 205b** from the open state to the closed state both when the risk low insulation error is below the risk threshold and when the TVS **202** has the safety voltage. Insulation error may be an error in the monitored insulation resistance in the TVS **202**

The processing circuitry **1002** may send instructions to the at least one load contactors **208a, 208b** to enter closed state.

The processing circuitry **1002** controls the change from open state to closed state. Controlling the change from open state to closed state may comprise triggering the change of the state, activating the change of the state, initiating the change of the state etc. As a consequence of step 805 may be that the at least one load contactors **208a, 208b** changes from open state to closed state.

Step **806:** This step corresponds to steps **705** and **706** in **FIG. 7****.** The processing circuitry **1002** determines that a result of an insulation monitoring, i.e. the second IRM **302,** of at least part of the TVS **202** indicates that a risk for insulation error is below a risk threshold. The insulation may be low when it is below an insulation threshold. In order to do this, the processing circuitry **1002** compares the monitored result with the risk threshold. The insulation monitoring may be an IRM. The purpose of the insulation monitoring may be described as monitoring whether or not the risk of low insulation in the TVS 202 is low hence there is low risks of electric shock or arching.

Step **807:** This step corresponds to step **707** in **FIG. 7****.** The processing circuitry **1002** determines to change the state of the at least one battery contactor **205a, 205b** from the open state to the closed state when the risk for insulation error is below the risk threshold. The processing circuitry **1002** may send instructions to the at least one battery contactor **205a, 205b** to enter closed state.

The processing circuitry **1002** controls the change from open state to closed state. Controlling the change from open state to closed state may comprise triggering the change of the state, activating the change of the state, initiating the change of the state etc. As a consequence of 807, the at least one load contactor **208a, 208b** may change from open state to closed state.

Step **808:** This step corresponds to step **708** in **FIG. 7****.** The processing circuitry **1002** may determine to perform the insulation monitoring at the TVS **202.**

Step **809:** This step corresponds to step **706** in **FIG. 7****.** The processing circuitry **1002** may determine whether or not a result of the insulation monitoring indicates that the risk for insulation error is below the risk threshold. In order to do this, the processing circuitry **1002** compares the monitored result with the risk threshold.

Step **810:** This step corresponds to step **708** in **FIG. 7****.** The processing circuitry **1002** may determine that there is an indication of a fault in the vehicle system **200** when the risk for insulation error in the TVS **202** is at or above the risk threshold. The processing circuitry **1002** may determine that there is an indication of a fault in the vehicle system **200** both when the risk for insulation error is at or above the risk threshold and when the TVS **202** has the safety voltage.

Step **811:** The processing circuitry **1002** may determine an action to be performed when it has been determined that there is an indication of a fault in the vehicle system **200.** The action may be for example fault detection, fault correction, and other precautionary actions to mitigate or remove the indicated fault may be taken. Thus, the risk of the fault causing damage to the vehicle system **200** is reduced or removed. The processing circuitry **1002** may trigger the action to be performed, for example by sending instructions to a fault detection system, to a fault correction system, to trigger an alarm, to send information indicating the fault to a user, e.g. a mobile phone, a computer or similar, just to mention some examples.

**FIG. 9** is another view of **FIG. 1****,** according to an example. **FIG. 9** illustrates a vehicle **100** comprising the vehicle system **200** and a computer system **1000.** The vehicle system **200** for handling contactors comprises a battery **201** electrically connected to a TVS **202** separated by at least one battery contactor **205a, 205b** and a HV load **203** electrically connected to the TVS **202** separated by at least one load contactor **208a, 208b.**

The HV load **203** may be a MDS or an HV unit with Y-capacitance above a threshold.

The computer system **1000** may be completely comprised in the vehicle **100,** or a first part of the computer system **1000** is located onboard the vehicle **100** and a second part of the computer system **1000** is located offboard the vehicle **100,** e.g. in a location remote from the vehicle **100,** or the whole computer system **1000** may be located offboard the vehicle **100.** When the computer system **1000** is at least partly located offboard the vehicle **100,** the offboard located computer system **1000** is arranged to be connected to the vehicle **100.**
The processing circuitry **1002** of a computer system **1000** is configured to determine that charging of the battery **201** has stopped. The charging may be stopped when the charging session is finished, when the vehicle **100** has been charged with a certain amount of charge, when a charging threshold has been reached, when a certain time from charging start has lapsed, when a charging stop has been triggered by a user, by the computer system **100** or by some other onboard or offboard system, that a charging cable has been removed from the charging inlet of the vehicle **100** etc. The processing circuitry **1002** may be configured to determine that the charging has stopped by obtaining information about the stopped charging. There may be a sensor, monitoring unit or any other suitable unit arranged to determine that the charging of the battery **201** has stopped and to provide information about the stopped charging to the processing circuitry **1002.**

The processing circuitry **1002** of a computer system **1000** is configured to determine to change a state of the at least one battery contactor **205a, 205b** from a closed state to an open state upon determining that charging of the battery 201 has reached the threshold. The processing circuitry **1002** may be configured to send instructions to the at least one battery contactor **205a, 205b** to enter open state. The processing circuitry **1002** is configured to control the change from closed state to open state. Controlling the change from closed state to open state may comprise triggering the change of the state, activating the change of the state, initiating the change of the state etc. As a consequence, the at least one battery contactor **205a, 205b** changes from closed state to open state.

The processing circuitry **1002** of a computer system **1000** is configured to determine that a voltage at a high voltage measuring point at the TVS **202** is close to or equal to zero. It is the value of the voltage that should be high that is very low or close to zero. The processing circuitry **1002** may be configured to determine this by obtaining information from a voltage sensor, voltage monitoring unit or any other suitable unit for monitoring voltage. When the voltage is close to zero, the voltage does not differ more than a predetermined amount of voltage from zero.

The processing circuitry **1002** of a computer system **1000** may be configured to determine that the TVS 202 has a safety voltage. In other words, the processing circuitry **1002** may determine that the TVS **202** reaches a safe voltage level, e.g. below 60V. A safety voltage may be a voltage being below a voltage threshold, for example below 60 V.

The processing circuitry **1002** of a computer system **1000** is configured to determine to change the state of the at least one load contactors **208a, 208b** from the open state to the closed state when the voltage is detected to be close to or equal to zero. The processing circuitry **1002** may be configured to determine to change the state of the at least one battery contactor **205a, 205b** from the open state to the closed state both when the risk for insulation error is below the risk threshold and when the TVS **202** has the safety voltage.

The processing circuitry **1002** may be configured to send instructions to the at least one load contactors **208a, 208b** to enter closed state. The processing circuitry **1002** is configured to control the change from open state to closed state. Controlling the change from open state to closed state may comprise triggering the change of the state, activating the change of the state, initiating the change of the state etc. As a consequence, the at least one load contactors **208a, 208b** changes from open state to closed state.

The processing circuitry **1002** of a computer system **1000** is configured to determine that a result of an insulation monitoring of at least part of the TVS **202** indicates that a risk for insulation error is below a risk threshold. The insulation may be low when it is below an insulation threshold. Insulation error may be an error in the monitored insulation resistance in the TVS **202.** In order to do this, the processing circuitry **1002** is configured to compare the monitored result with the risk threshold. The insulation monitoring may be an IRM. The purpose of the insulation monitoring may be described as monitoring whether or not the risk of low insulation in the TVS 202 is low hence there is low risks of electric shock or arching.

The processing circuitry **1002** of a computer system **1000** is configured to determine to change the state of the at least one battery contactor **205a, 205b** from the open state to the closed state when the risk for insulation error is below the risk threshold. The processing circuitry **1002** may be configured to send instructions to the at least one battery contactor **205a, 205b** to enter a closed state. The processing circuitry **1002** is configured to control the change from open state to closed state. Controlling the change from open state to closed state may comprise triggering the change of the state, activating the change of the state, initiating the change of the state etc. As a consequence, the at least one battery contactor **205a, 205b** changes from open state to closed state.

The processing circuitry **1002** of a computer system **1000** may be configured to determine to perform the insulation monitoring at the TVS 202.

The processing circuitry **1002** of a computer system **1000** may be configured to determine whether or not a result of the insulation monitoring indicates that the risk for insulation error is below the risk threshold. In order to do this, the processing circuitry **1002** may be configured to compare the monitored result with the risk threshold.

The processing circuitry **1002** of a computer system **1000** may be configured to determine that there is an indication of a fault in the vehicle system **200** when the risk for insulation error in the TVS **202** is at or above the risk threshold. The processing circuitry **1002** may be configured to determine that there is an indication of a fault in the vehicle system **200** both when the risk for insulation error is at or above the risk threshold and when the TVS **202** has the safety voltage.

The processing circuitry **1002** of a computer system **1000** may be configured to determine an action to be performed when it has been determined that there is an indication of a fault in the vehicle system **200.** The action may be for example fault detection, fault correction, and other precautionary actions to mitigate or remove the indicated fault may be taken. Thus, the risk of the fault causing damage to the vehicle system **200** is reduced or removed. The processing circuitry **1002** may be configured to trigger the action to be performed, for example by sending instructions to a fault detection system, to a fault correction system, to trigger an alarm, to send information indicating the fault to a user, e.g. a mobile phone, a computer or similar, just to mention some examples.

A computer program product comprising program code for performing, when executed by a processing circuitry **1002,** the method described herein.

A non-transitory computer-readable storage medium comprises instructions, which when executed by a processing circuitry **1002,** cause the processing circuitry **1002** to perform the method described herein.

**FIG. 10** is a schematic diagram of a computer system **1000** for implementing examples disclosed herein. The computer system **1000** is adapted to execute instructions from a computer-readable medium to perform these and/or any of the functions or processing described herein. The computer system **1000** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **1000** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **1000** may comprise at least one computing device or electronic device capable of including firmware, hardware, and/or executing software instructions to implement the functionality described herein. The computer system **1000** may include processing circuitry **1002** (e.g., processing circuitry including one or more processor devices or control units), a memory **1004,** and a system bus **1006.** The computer system **1000** may include at least one computing device having the processing circuitry **1002.** The system bus **1006** provides an interface for system components including, but not limited to, the memory **1004** and the processing circuitry **1002.** The processing circuitry **1002** may include any number of hardware components for conducting data or signal processing or for executing computer code stored in memory **1004.** The processing circuitry **1002** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **1002** may further include computer executable code that controls operation of the programmable device.

The system bus **1006** may be any of several types of bus structures that may further interconnect to a memory bus (with or without a memory controller), a peripheral bus, and/or a local bus using any of a variety of bus architectures. The memory **1004** may be one or more devices for storing data and/or computer code for completing or facilitating methods described herein. The memory **1004** may include database components, object code components, script components, or other types of information structure for supporting the various activities herein. Any distributed or local memory device may be utilized with the systems and methods of this description. The memory **1004** may be communicably connected to the processing circuitry **1002** (e.g., via a circuit or any other wired, wireless, or network connection) and may include computer code for executing one or more processes described herein. The memory **1004** may include non-volatile memory **1008** (e.g., read-only memory (ROM), erasable programmable read-only memory (EPROM), electrically erasable programmable read-only memory (EEPROM), etc.), and volatile memory **1010** (e.g., random-access memory (RAM)), or any other medium which can be used to carry or store desired program code in the form of machine-executable instructions or data structures and which can be accessed by a computer or other machine with processing circuitry **1002.** A basic input/output system (BIOS) **1012** may be stored in the non-volatile memory **1008** and can include the basic routines that help to transfer information between elements within the computer system **1000.**

The computer system **1000** may further include or be coupled to a non-transitory computer-readable storage medium such as the storage device **1014,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **1014** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **1014** and/or in the volatile memory **1010,** which may include an operating system **1016** and/or one or more program modules **1018.** All or a portion of the examples disclosed herein may be implemented as a computer program **1020** stored on a transitory or non-transitory computer-usable or computer-readable storage medium (e.g., single medium or multiple media), such as the storage device **1014,** which includes complex programming instructions (e.g., complex computer-readable program code) to cause the processing circuitry **1002** to carry out actions described herein. Thus, the computer-readable program code of the computer program **1020** can comprise software instructions for implementing the functionality of the examples described herein when executed by the processing circuitry **1002.** In some examples, the storage device **1014** may be a computer program product (e.g., readable storage medium) storing the computer program **1020** thereon, where at least a portion of a computer program **1020** may be loadable (e.g., into a processor) for implementing the functionality of the examples described herein when executed by the processing circuitry **1002.** The processing circuitry **1002** may serve as a controller or control system for the computer system **1000** that is to implement the functionality described herein.

The computer system **1000** may include an input device interface **1022** configured to receive input and selections to be communicated to the computer system **1000** when executing instructions, such as from a keyboard, mouse, touch-sensitive surface, etc. Such input devices may be connected to the processing circuitry **1002** through the input device interface **1022** coupled to the system bus **1006** but can be connected through other interfaces, such as a parallel port, an Institute of Electrical and Electronic Engineers (IEEE) 1394 serial port, a Universal Serial Bus (USB) port, an IR interface, and the like. The computer system **1000** may include an output device interface **1024** configured to forward output, such as to a display, a video display unit (e.g., a liquid crystal display (LCD) or a cathode ray tube (CRT)). The computer system **1000** may include a communications interface **1026** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Below follows a list of examples 1-20. Each example can be combined with any of the other examples discussed above.

**Example 1:** A computer system **1000** for handling contactors in a vehicle system 200, wherein the vehicle system **200** comprises a battery **201** electrically connected to a TVS **202** separated by at least one battery contactor **205a, 205b,** and a HV load **203** electrically connected to the TVS **202** separated by at least one load contactor **208a, 208b.** The computer system **1000** comprising processing circuitry **1002** configured to:
- determine that charging of the battery **201** has stopped;
- determine to change a state of the at least one battery contactor **205a, 205b** from a closed state to an open state upon determining that charging of the battery **201** has stopped;
- determine that a voltage at a high voltage measuring point at the TVS **202** is close to or equal to zero;
- determine to change the state of the at least one load contactor **208a, 208b** from the open state to the closed state when the high voltage at the TVS **202** is detected to be close to or equal to zero;
- determine that a result of an insulation monitoring of at least part of the TVS **202** indicates that a risk for insulation error is below a risk threshold; and to
- determine to change the state of the at least one battery contactor **205a, 205b** from the open state to the closed state when the risk for insulation error is below the risk threshold.

**Example 2:** The computer system **1000** of example 1, wherein the processing circuitry **1002** is further configured to:
- determine to perform the insulation monitoring at the TVS **202;** and to
- determine whether or not the result of the insulation monitoring indicates that the risk for insulation error is below the risk threshold.

**Example 3:** The computer system **1000** of any of the preceding examples, wherein the processing circuitry **1002** is further configured to:
- determine that there is an indication of a fault in the vehicle system **200** when the risk for insulation error is at or above the risk threshold.

**Example 4:** The computer system **1000** of any of the preceding example, wherein the processing circuitry **1002** is further configured to:
- determine that the TVS **202** has a safety voltage; and to
- change the state of the at least one battery contactor **205a, 205b** from the open state to the closed state when the risk for insulation error is below the risk threshold and when the TVS **202** has the safety voltage.

**Example 5:** The computer system **1000** of any of the preceding example, wherein the processing circuitry **1002** is further configured to:
- determine that there is an indication of a fault in the vehicle system **200** when the risk for insulation error is at or above the risk threshold and when the TVS **202** has the safety voltage.

**Example 6:** The computer system **1000** of any of the preceding example, wherein the processing circuitry **1002** is further configured to:
- determine an action to be performed when it has been determined that there is an indication of a fault in the vehicle system **200.**

**Example 7:** The computer system **1000** of any of the preceding example, wherein the HV load **203** is a MDS or an HV unit with Y-capacitance above a threshold.

**Example 8:** The computer system **1000** of any of the preceding example, wherein the insulation monitoring is an IRM.

**Example 9:** A vehicle system **200** for handling contactors, wherein the vehicle system **200** comprises:
- a battery **201** electrically connected to a TVS **202** separated by at least one battery contactor **205a, 205b;** and
- a HV load **203** electrically connected to the TVS **202** separated by at least one load contactor **208a, 208b.**

**Example 10: A** vehicle **100** comprising a vehicle system **200** of example 9; and a computer system **1000** of any of examples 1-8,

**Example 11:** A computer-implemented method for handling contactors in a vehicle system **200,** wherein the vehicle system **200** comprises a battery **201** electrically connected to a TVS **202** separated by at least one battery contactor **205a, 205b** and a HV load **203** electrically connected in parallel to the TVS **202** separated by at least one load contactor **208a, 208b.** The method comprises:
- *determining* **701, 801,** by processing circuitry **1002** of a computer system **1000,** that charging of the battery **201** has stopped;
- *determining* **702, 802,** by the processing circuitry **1002,** to change a state of the at least one battery contactor **205a, 205b** from a closed state to an open state upon determining that charging of the battery **201** has reached the threshold;
- *determining* **703, 803,** by the processing circuitry **1002,** that a voltage at a high voltage measuring point at the TVS **202** is close to or equal to zero;
- *determining* **704, 804,** by the processing circuitry **1002,** to change the state of the at least one load contactors **208a, 208b** from the open state to the closed state when the voltage is detected to be close to or equal to zero;
- *determining* **705, 706, 806,** by the processing circuitry **1002,** that a result of an
- insulation monitoring of at least part of the TVS **202** indicates that a risk for insulation error is below a risk threshold; and
- *determining* **707, 807,** by the processing circuitry **1002** to change the state of the at least one battery contactor **205a, 205b** from the open state to the closed state when the risk for insulation error is below the risk threshold.

**Example 12:** The method of example 11, further comprising:
- *determining* **705, 808,** by the processing circuitry **1002,** to perform the insulation monitoring at the TVS **202;** and
- *determining* **706, 809,** by the processing circuitry **1002,** whether or not a result of the insulation monitoring indicates that the risk for insulation error is below the risk threshold.

**Example 13:** The method of any of examples 11-12, further comprising:
- *determining* **708, 810,** by the processing circuitry **1002,** that there is an indication of a fault in the vehicle system **200** when the risk for insulation error in the TVS **202** is at or above the risk threshold.

**Example 14:** The method of any of examples 11-13, further comprising:
- *determining,* by the processing circuitry **1002,** that the TVS **202** has a safety voltage; and to
- *changing,* by the processing circuitry **1002,** the state of the at least one battery contactor **205a, 205b** from the open state to the closed state when the risk for insulation error is below the risk threshold and when the TVS **202** has the safety voltage.

**Example 15:** The method of any of examples 11-14, further comprising:
- *determining,* by the processing circuitry **1002,** that there is an indication of a fault in the vehicle system **200** when the risk for insulation error is at or above the risk threshold and when the TVS **202** has the safety voltage.

**Example 16:** The method of any of examples 11-15, further comprising:
- *determining,* by the processing circuitry **1002,** an action to be performed when it has been determined that there is an indication of a fault in the vehicle system **200.**

**Example 17:** The method of any of examples 11-16, wherein the HV load **203** is a MDS **203** or an HV unit with Y-capacitance above a threshold.

**Example 18:** The method of any of examples 11-17, wherein the insulation monitoring is an IRM.

**Example 19:** A computer program product comprising program code for performing, when executed by a processing circuitry **1002,** the method of any of examples 11-18.

**Example 20:** A non-transitory computer-readable storage medium comprising instructions, which when executed by a processing circuitry **1002,** cause the processing circuitry **1002** to perform the method of any of examples 11-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (1000) for handling contactors in a vehicle system (200), wherein the vehicle system (200) comprises:
a battery (201) electrically connected to a Traction Voltage System, TVS (202) separated by at least one battery contactor (205a, 205b), and
a High Voltage, HV, load (203) electrically connected to the TVS (202) separated by at least one load contactor (208a, 208b),
wherein the computer system (1000) comprising processing circuitry (1002) configured to:
determine that charging of the battery (201) has stopped;
determine to change a state of the at least one battery contactor (205a, 205b) from a closed state to an open state upon determining that charging of the battery (201) has stopped;
determine that a voltage at a high voltage measuring point at the TVS (202) is close to or equal to zero;
determine to change the state of the at least one load contactors (208a, 208b) from the open state to the closed state when the high voltage at the TVS (202) is detected to be close to or equal to zero;
determine that a result of an insulation monitoring of at least part of the TVS (202) indicates that a risk for insulation error is below a risk threshold; and to
determine to change the state of the at least one battery contactor (205a, 205b) from the open state to the closed state when the risk for insulation error is below the risk threshold.

2. The computer system (1000) of claim 1, wherein the processing circuitry (1002) is further configured to:
determine to perform the insulation monitoring at the TVS (202); and to
determine whether or not the result of the insulation monitoring indicates that the risk for insulation error is below the risk threshold.

3. The computer system (1000) of any of the preceding claims, wherein the processing circuitry (1002) is further configured to:
determine that there is an indication of a fault in the vehicle system (200) when the risk for insulation error is at or above the risk threshold.

4. The computer system (1000) of any of the preceding claims, wherein the processing circuitry (1002) is further configured to:
determine that the TVS (202) has a safety voltage; and to
change the state of the at least one battery contactor (205a, 205b) from the open state to the closed state when the risk for insulation error is below the risk threshold and when the TVS (202) has the safety voltage.

5. The computer system (1000) of claims 3-4, wherein the processing circuitry (1002) is further configured to:
determine that there is an indication of a fault in the vehicle system (200) when the risk for insulation error is at or above the risk threshold and when the TVS (202) has the safety voltage.

6. The computer system (1000) of any of claims 3-5, wherein the processing circuitry (1002) is further configured to:
determine an action to be performed when it has been determined that there is an indication of a fault in the vehicle system (200).

7. The computer system (1000) of any of the preceding claims, wherein the HV load (203) is a Motor Drive System, MDS, (203) or an HV unit with Y-capacitance above a threshold.

8. The computer system (1000) of any of the preceding claims, wherein the insulation monitoring is an Insulation Resistance Monitoring, IRM.

9. A vehicle system (200) for handling contactors,
wherein the vehicle system (200) comprises:
a battery (201) electrically connected to a Traction Voltage System, TVS (202) separated by at least one battery contactor (205a, 205b); and
a High Voltage, HV, load (203) electrically connected to the TVS (202) separated by at least one load contactor (208a, 208b).

10. A vehicle (100) comprising:
a vehicle system (200) of claim 9; and
a computer system (1000) of any of claims 1-8,

11. A computer-implemented method for handling contactors in a vehicle system (200), wherein the vehicle system (200) comprises:
a battery (201) electrically connected to a Traction Voltage System, TVS (202) separated by at least one battery contactor (205a, 205b), and
a High Voltage, HV, load (203) electrically connected in parallel to the TVS (202) separated by at least one load contactor (208a, 208b),
wherein the method comprises:
*determining* (701, 801), by processing circuitry (1002) of a computer system (1000), that charging of the battery (201) has stopped;
*determining* (702, 802), by the processing circuitry (1002), to change a state of the at least one battery contactor (205a, 205b) from a closed state to an open state upon determining that charging of the battery (201) has reached the threshold;
*determining* (703, 803), by the processing circuitry (1002), that a voltage at a high voltage measuring point at the TVS (202) is close to or equal to zero;
*determining* (704, 804), by the processing circuitry (1002), to change the state of the at least one load contactors (208a, 208b) from the open state to the closed state when the voltage is detected to be close to or equal to zero;
*determining* (705, 706, 806), by the processing circuitry (1002), that a result of an insulation monitoring of at least part of the TVS (202) indicates that a risk for insulation error is below a risk threshold; and
*determining* (707, 807), by the processing circuitry (1002) to change the state of the at least one battery contactor (205a, 205b) from the open state to the closed state when the risk for insulation error is below the risk threshold.

12. The method of claim 11, further comprising:
*determining* (705, 808), by the processing circuitry (1002), to perform the insulation monitoring at the TVS (202); and
*determining* (706, 809), by the processing circuitry (1002), whether or not a result of the insulation monitoring indicates that the risk for insulation error is below the risk threshold.

13. The method of any of claims 11-12, further comprising:
*determining* (708, 810), by the processing circuitry (1002), that there is an indication of a fault in the vehicle system (200) when the risk for insulation error in the TVS (202) is at or above the risk threshold.

14. A computer program product comprising program code for performing, when executed by a processing circuitry (1002), the method of any of claims 11-13.

15. A non-transitory computer-readable storage medium comprising instructions, which when executed by a processing circuitry (1002), cause the processing circuitry (1002) to perform the method of any of claims 11-13.
